# EUROPEAN PATENT APPLICATION

(11) **EP 1 193 031 A1**
(43) Date of publication of application: **03.04.2002**
(21) Application number: 00121485.7
(22) Date of filing: 29.09.2000
(51) Int. Cl.: B24B 37/04, B24B 41/06, H01L 21/304

(54) **Arrangement for polishing disk-like objects**

(71) Applicant: Infineon Technologies SC300 GmbH & Co. KG, 01099 Dresden (DE)
(72) Inventor: Ebner, Katrin, 01109 Dresden (DE); Glashauser, Walter, 82041 Oberhaching (DE)
(74) Representative: Fischer, Volker, Dipl.-Ing.

(57) **Abstract**

A polish head (3) for Chemical Mechanical Polishing comprises a backing film (5) made of silicone on a rigid support element (6, 7), preferably consisting of amorphous ceramic. The silicone backing film (5) is fabricated by molding, thereby enabling an appropriate cross-sectional shape for specific polishing needs. The invention provides a uniform polishing of a semiconductor wafer (4).

## Description

The invention refers to an arrangement for polishing disk-like objects comprising a polish platen and a polish head with a backing film, especially for polishing semiconductor wafers.

In semiconductor wafer manufacturing the wafer obtains an uneven surface in the process of depositing and growing of different films and materials. Especially with small feature sizes, these non-planarities of the wafer surface lead to alignment errors during lithography. A common process to improve uniformity is a polishing of the wafer surface. The backside of the wafer is held by a polish head of the polishing tool and the front side to be polished is moved across a pad on the platen of the polish tool. The head is rotated around its own axis as well as around another axis together with multiple polishing heads. A slurry comprising a specific composition of different ingredients interacts between the wafer and the polish pad to provide appropriate polish effects as well as cooling. This process of polishing semiconductor wafers is referred to as Chemical Mechanical Polishing (CMP). CMP may also be applied to other manufacturing processes of disk-like objects such as CDs or flat panel substrates or the like.

One critical factor in CMP is uniformity. When the backside of the wafer within the polishing head is supported by a polyurethane film there are inherent disadvantages. Polyurethane is inhomogeneous having zones of different hardness and different density. This is due to the fact that a polyurethane backing film is fabricated by foaming which is poorly controllable. The film is cut off from bulk material. The polyurethane backing film has varying compressibility so that the force applied to the wafer backside results in an inhomogeneous polishing result on the polished surface of the wafer.

Another disadvantage of polyurethane backing films is that the film sucks liquid into its holes of the foam structure. Especially those holes which are cut and open on the surface of the backing film accept liquid from the slurry. The sucking of liquid into the polyurethane backing film results in a further introduction of non-uniformity to the polishing process.

In US 6,012,964 a CMP apparatus is disclosed which seeks to improve uniformity. The polish head has a soft backing pad facing the backside of the wafer to be polished which is supported by a hard sheet. The hard sheet is applied with air pressure to adjust the shape of the hard sheet and compensate uniformity problems. The backing film can be made of various materials including silicone rubber. The shape of the surface of the hard sheet is controlled by the air pressure applied to the pressure chamber behind the hard sheet. Since the surface shape of the hard sheet is not rigid and depends on the pressure applied to the pressure chamber, uniformity problems remain.

It is an object of the present invention to provide a polishing arrangement for disk-like objects which provides better uniformity during polishing.

This object is solved by an arrangement for polishing disk-like objects comprising: a platen which contacts a first surface of the object which is to be polished; a polish head which comprises: a backing film which is removably attached to said polish head to contact a second surface of the object opposite to said surface to be polished; a support element carrying said backing film which is rigid; whereby said backing film comprises silicone.

The polish head according to the arrangement of the invention has a rigid, incompressible support for the backing film the surface of which has a constant shape. For better uniformity and controllability of the polish process, the backing film which holds the backside of the wafer comprises silicone. Compared to a polyurethane backing film which is made from a foam, silicone has the advantage that it is made from a liquid. The liquid is introduced into a molding form. Compared to the poorly controllable process of foaming, the result of molding a backing film can be tightly controlled.

Since the silicone backing film is made from a liquid phase, the finished backing pad is an inherently uniform material having the same density and compressibility throughout its body. A silicone backing pad does not leak any air so that it can be attached to the polish head by underpressure. There is no need to glue the backing film to its support on the polish head so that uniformity is further improved. By avoiding any glue a backing film can easily be replaced by a new silicone backing film at the end of its lifetime. Preferably, the support for the backing film is a ceramic plate or chuck which is rigid and provides an incompressible support for the backing film the surface of which always has the same constant shape. A ceramic chuck is amorphous so that an evenly distributed vacuum can be provided through the ceramic chuck to hold the backing film onto the chuck. This vacuum is provided by a vacuum chamber at the surface of the ceramic chuck which is opposite to the backing film.

There is another vacuum chamber which provides a vacuum to the backside of the wafer through tubes. The tubes are projecting from this latter vacuum chamber through the chamber providing the vacuum to the ceramic chuck, protruding through the ceramic chuck and protruding through the silicone backing film and finally ending close to the back surface of the wafer.

Since the silicone backing film does not leak any air the wafer is tightly attached to the backing film. In order to facilitate the removal of the wafer the surface of the backing film facing the backside of the wafer is provided with a microstructure. The microstructure has enhanced elements which contact the wafer backside and has recessed elements that do not contact the wafer backside. Thereby the contact area is reduced. The adhesive force holding the wafer at the backing film is thereby also reduced. With an appropriate relation between enhanced elements and recessed elements of the microstructure it can be accomplished that the wafer does not stick to the backing film any more when the vacuum for holding the wafer is switched off. The microstructure is applied to the surface of the backing film by a complementary shape in the molding from. This shape can be produced by applying a lithography step comparable to a lithography step for patterning a semiconductor wafer surface during semiconductor wafer manufacturing. To achieve the microstructure through lithography the surface of the molding is subjected to a photoresist which is exposed to optical radiation. The structure is formed by etching the unprotected areas of the molding surface.

By molding the silicone backing film it is possible to provide any macroscopic shape to the backing film in order that any already known non-uniformity of the wafer be polished is compensated for. For example, the wafer needs to be polished more in the center than at its end or vice versa. To compensate this non-uniformity of the wafer the backing film can be formed convex e.g. the backing film is thicker at its' center than at its circumference and can be formed concave, e.g. thinner at its center than at its circumference, respectively. Alternatively, the backing film has a macroscopic recess in its center and projecting parts at its circumference. The center recess does not touch the backside of the wafer whereas the projecting parts contact the wafer. Thereby a vacuum is enclosed at the center of the backing film. The projecting parts can also be provided with the microstructure. Any other conceivable shape of the surface facing the backside of the wafer can be manufactured by an appropriate complementary shape of the molding.

Another solution to compensate for already known non-uniformities of the wafer to be polished is to provide the backing film with zones of different hardness. Preferably those zones have concentric shape with respect to the center of the backing film, although different radial sections of the backing film may also have different hardness. All depends on the flexibility of the molding process to fabricate the silicone backing film. The hardness is controllable by the addition of solid particles like silicon particles or aluminum oxide particles. Other solid materials are possible. Depending on the electrical behavior of the added material any electrostatic fields introduced during the polish process can be eliminated.

The invention is now described with respect to the figures in the drawings. Respective elements in different figures are referenced by the same numerals.
- Figure 1: shows a first embodiment of an arrangement for polishing a semiconductor wafer;
- Figure 2: shows a second embodiment of the arrangement;
- Figure 3: shows different views of a molding form for the fabrication of a silicone backing film;
- Figure 4: shows various embodiments of a microstructure of the surface of a silicone backing film; and
- Figure 5: shows various cross sections through a silicone backing film.

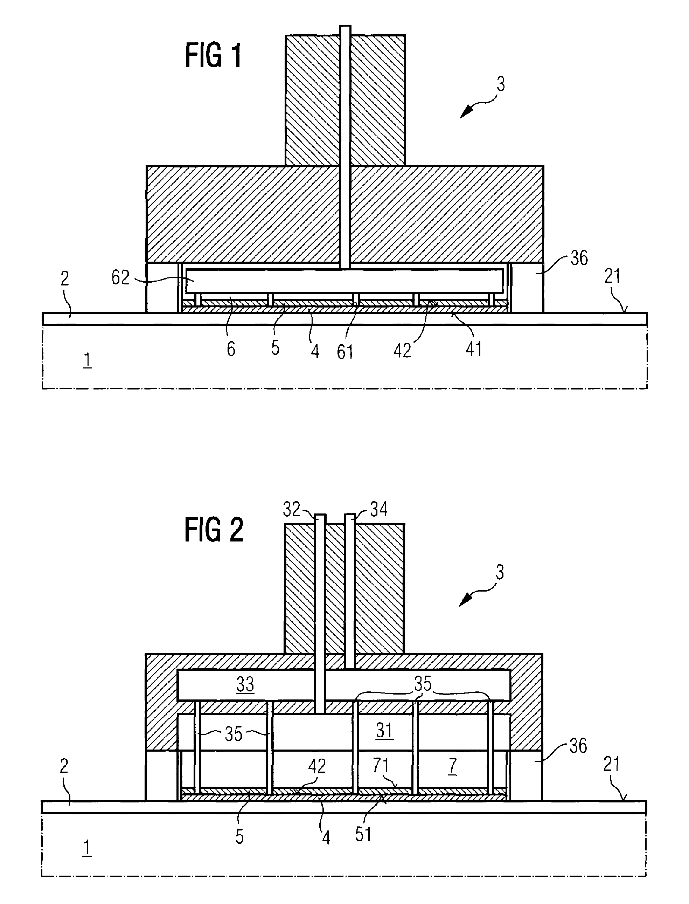

The arrangement for polishing disk-like objects according to figure 1 is especially applicable for polishing semiconductor wafers for the manufacturing of integrated circuits. The arrangement comprises a table or polish platen 1 on which a polish pad 2 is attached. A polish head 3 holds a wafer 4, the front side 41 of which is moved across the polish pad 2 for polishing. A liquid slurry 21 or a polish pad with fixed abrasive inside of the polish pad is inserted to control friction and to accomplish the Chemical Mechanical Polishing. An arrangement of, for example, three or four polish heads is provided, each rotating around its own axis and all of them rotating around the axis of the head arrangement. The wafer 4 is pressed onto the polish pad 2 by the polish head 3. The downforce is applied through a backing film or backing pad 5. The backing film 5 is supported through the polish head by a backing film support 6. The backing film support 6 is rigid having an incompressible, indistortable constant shape. According to the invention the backing film 5 is made of silicone. A retainer ring 6 withstands the radial forces during polish. The support 6 applies a vacuum to the backside of the wafer 4 through a vacuum chamber 62 and vacuum holes 61. By applying the vacuum the wafer is sucked to the backing film 5. By switching off the vacuum the wafer is released from the backing film 5. Further, a vacuum is supplied to suck the silicone backing film 5 to the support 6.

Figure 2 shows a preferred embodiment of the polish head 3. The support element for the backing film 5 is a ceramic chuck 7. A vacuum chamber 31 is provided above the ceramic chuck 7. A channel 32 connects the vacuum chamber 31 to a vacuum generator. The ceramic chuck 7, being amorphous, enables the vacuum in the chamber 31 to reach the silicone backing film 5 to suck it to the ceramic chuck 7. With the amorphous ceramic chuck 7 the vacuum in the chamber 31 is evenly distributed across the surface 71 which contacts the silicone backing film. Since silicone does not leak air, the backing film 5 is tightly held on the ceramic chuck 7 and can be released easily by switching off the vacuum in the chamber 31. Compared to a polyurethane backing film, no glue is necessary to stick the backing film to the support 7 so that a replacement of a used backing film is facilitated and non-uniformities due to air bubbles enclosed by the glue are avoided. The surface 71 of the ceramic chuck is rigid and has a constant shape even when the polish head 3 is pressed onto the platen 1.

An additional vacuum chamber 33 provided with a vacuum by another vacuum channel 34 is arranged above the vacuum chamber 31. Vacuum tubes 35 range from the vacuum chamber 33 through the vacuum chamber 31 also protruding through the ceramic chuck 7 as well as the backing film 5. The tubes 35 are on the backside of the wafer 4. When a vacuum is applied to the backside of the wafer 4 through the vacuum tubes 35 the wafer is tightly held to the backing film 5. When switching off the vacuum after polishing the wafer is released from the polish head 3.

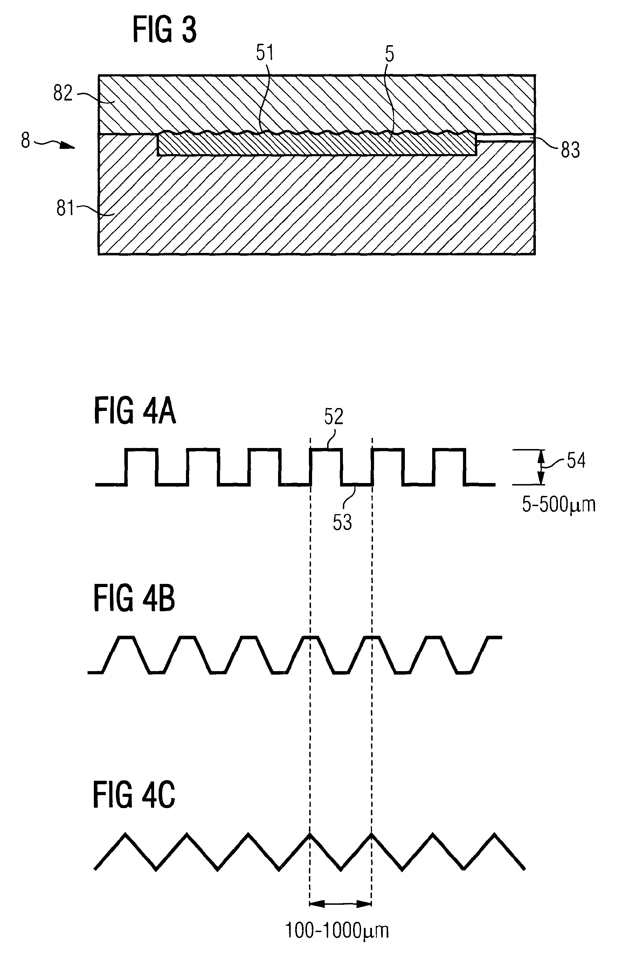

The backing film 5 is fabricated by a molding process in a molding form shown in cross-sectional view in figure 3. The molding or casting form 8 has a bottom part 81 and a top part 82. Liquid silicone is inserted through a channel 83 between the top and the bottom parts and is transformed to a solid film. Due to the fact that the silicone film is produced from a liquid, the solid silicone backing film is very homogeneous having substantially no variation in density and compressibility. Further, the cross-sectional shape of the backing film can be adapted to various requirements. It is also possible to provide the surface of the silicone backing film, which is facing the backside of the wafer to be polished, with a microstructure as explained below. Further, it is possible to insert additional components into the silicone to adopt specific hardness requirements to various radial and/or concentric zones of the silicone backing film.

The silicone backing film 5 is impermeable for air. In order to ease the removal of the wafer 4 from the backing film 5 after polishing the surface 51 of the silicone backing film 5 facing to the backside of the wafer 4 is provided with a microstructure. Preferred embodiments of the microstructure are shown in figure 4A, 4B and 4C. The microstructure has projecting or enhanced portions 52 and recessed portions 53. The enhanced portions 52 make contact to the backside 42 of the wafer 4, whereas the recessed portions 53 do not contact the backside wafer surface 42. With enhanced and recessed portions 52, 53 forming a microstructure, the contact area between the backing film 5 and the wafer backside surface 42 is reduced. The height 54 of the projections is to be adjusted in the range 5 to 500 µm. The sequence of projections and recesses is regular. Two neighboring projections repeat after 100 to 1000 µm. A cross-section through a projecting element can be of rectangular shape as shown in figure 4A or of tapered shape as shown in figure 4B or of triangular shape as shown in figure 4C.

The complementary shape of the microstructure is provided by the molding or casting form 8 of figure 3 comprising a bottom part 81 and a top part 82. The top part 82 is provided with the microstructure 51. The microstructure is formed by a lithography process. The top part 82 is preferably a metal plate or a glass plate. The top part 82 is coated with a photoresist and structured by light exposure. After developing the photoresist and removal of the developed portions (or undeveloped portions depending on the type of the photoresist) the exposed metal or glass sections are etched by a wet etching chemical or by dry etching (plasma etch). As a result the structures as shown in figure 4A through 4C are achieved. Liquid silicone is feed into the moulding form 8 through feeding channel 83 and is then moulded.

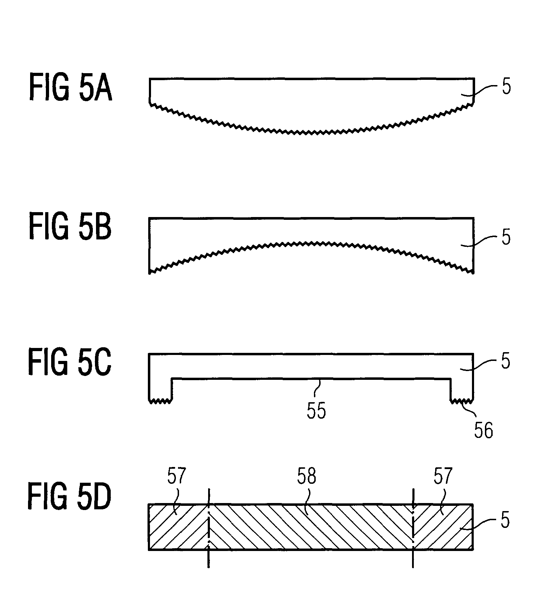

By appropriate macroscopic shaping of the molding in figure 3 the various cross-sectional shapes as shown in figure 5A through 5C are obtained. The convex form shown in figure 5A has a cross-sectional shape where the thickness decreases from the center to the circumference. Polishing a wafer with the backside film of figure 5A in a polish head of figures 1 or 2 provides faster polishing at the center of the wafer than at the outside portions of the wafer. The macroscopic shape is easily achieved by the appropriate shaping of the top part 82 of the molding form 8. The convex cross-sectional shape of the backing film in figure 5B has a smaller thickness in the center which increases radially to its circumference. The concaveness of the backside film can be obtained by an appropriate shape of the top part 82 of the molding form 8. With the concave backing film as shown in figure 5B the center of the wafer is polished more slowly as compared to the outer parts of the wafer. Another preferred shape of the backside film is depicted in figure 5C. The macroscopic cross-sectional structure of the circular backing film is U-shaped and has a macroscopic recess 55 at the center and a projecting portion 56 at the circumference. The surface touching the backside of the wafer 4 of the projecting portion 56 has a microstructure as is explained with respect to figure 4. The recess section 55 encloses an air cushion behind the wafer.

As shown in principle in figure 5D the backing film 5 can have portions of different hardness. For example, the portion 58 in the center of the backing film 5 is harder and has less compressibility than the circular portion 57 surrounding the inner portion 58. The center is polished faster than the outer part of the wafer. Different hardness is achieved by adding particles to the silicon rubber. The particles are mixed into the liquid silicone before the molding form 8 is filled with liquid silicone. The particles may comprise silicon or aluminum-oxide or a mixture of both. Other particles which do not introduce any contamination to silicon wafers are also possible.

The invention as disclosed above achieves better uniformity of Chemical Mechanical Polishing of semiconductor wafers by various effects. The silicone backing film can easily be suck to the ceramic chuck or support plate within the polish head by the application of a vacuum thereby avoiding any glue. This provides a uniform adhesion of the silicone backing film to the polish head. The replacement of a used and mature backing film is easy and safe enabling high turnaround time by simply switching the vacuum on and off provided through the amorphous ceramic chuck. The ability to manufacture silicone by molding in an appropriately designed molding/casting form enables the backing film to be adopted to specific polishing characteristics. By appropriate macroscopical shape of the silicone backing film achieved by the molding form, different removal speeds of the material to be polished can be achieved across the wafer surface. A comparable effect can be achieved by an appropriate adding of particles into the silicone. In addition, a microstructure on the contact surface of the backing film to the backside of the wafer serves for good adhesion to the backing film during polishing and easy removal from the backing film when the polish process is finished. Overall, the use of a silicone backing film in a polish arrangement according to the invention provides a more accurate polishing, a high turnaround time thereby providing better quality integrated circuits.

### List of reference signs

- 1: platen
- 2: pad
- 21: slurry
- 3: polish head
- 31: chamber
- 32: channel
- 33: vacuum chamber
- 34: channel
- 35: channel
- 36: retainer ring
- 4: wafer
- 41: wafer surface
- 42: wafer surface
- 5: backing film
- 51: backing film surface
- 52: enhanced portion
- 53: recessed portion
- 54: height
- 55: macroscopic recess
- 56: projecting portion
- 57: surrounding portion
- 58: inner portion
- 6: backing film support
- 61: vacuum holes
- 62: vacuum chamber
- 8: moulding form
- 81: bottom part
- 82: top part
- 83: feeding channel

## Claims

1. Arrangement for polishing disk-like objects comprising:
- a platen (2) which contacts a first surface (41) of the object (4) which is to be polished;
- a polish head (3) which comprises:
- a backing film (4) which is removably attached to said polish head (3) to contact a second surface (42) of the object (4) opposite to said surface (41) to be polished;
- a support element (6, 7) carrying said backing film which is rigid; whereby
- said backing film (5) comprises silicone.

2. Arrangement according to claim 1,
**characterised in that**
said object (5) is a semiconductor wafer, especially a silicon wafer.

3. Arrangement according to claims 1 or 2,
**characterised in that**
said support element (7) comprises an amorphous ceramic.

4. Arrangement according to claim 3,
**characterised in that**
said polish head (3) has a vacuum generator (32) to supply a vacuum to said ceramic support element (7) to hold said backing film (5) on said ceramic support element (7).

5. Arrangement according to claim 4,
**characterised in that**
said polish head (3) has a first vacuum chamber (31) to supply a vacuum to the ceramic support element (7), and has a second vacuum chamber (33) above said first vacuum chamber (31), and has a plurality of tubes (35) projecting from said second vacuum chamber (33) through said first chamber (31) and through said ceramic support element (7) and through said backing film (5) ending above said second surface (42) of said object (4) to supply a vacuum to said second surface (42) of said object (4) to hold said object onto said backing film.

6. Arrangement according to any of claims 1 to 5,
**characterised in that**
said backing film (4) has a surface which contacts said second surface (42) of said object (4), said surface of said backing film having a microstructure (52, 53) comprising a plurality of enhanced portions (52) to contact said second surface (42) of said object (4) and a plurality of recessed portions (53) which do not contact said second surface (42) of said object (4).

7. Arrangement according to claim 6,
**characterised in that**
said surface of said backing film (5) being concave or being convex or having a U-shape with a macroscopic recess in the center (55) which does not contact the object (4).

8. Arrangement according to any of claims 1 to 7,
**characterised in that**
said backing film (5) has concentric zones (58; 57) of different hardnesses.

9. Arrangement according to any of claims 1 to 8,
**characterised in that**
said backing film (5) comprises solid particles, especially made of silicon or aluminum oxide.
